# EUROPÄISCHE PATENTSCHRIFT

(11) **EP 1 177 628 B1**
(45) Veröffentlichungstag und Bekanntmachung des Hinweises auf die Patenterteilung: **06.08.2003**
(21) Anmeldenummer: 00931090.5
(22) Anmeldetag: 28.04.2000
(51) Int. Cl.: H03K 5/12

(54) **SCHALTUNGSANORDNUNG ZUR ERZEUGUNG VON STROMPULSEN IM VERSORGUNGSSTROM INTEGRIERTER SCHALTUNGEN**
CIRCUIT ARRANGEMENT FOR GENERATING CURRENT IMPULSES IN THE SUPPLY CURRENT OF INTEGRATED CIRCUITS
MONTAGE SERVANT A PRODUIRE DES IMPULSIONS ELECTRIQUES DANS LE COURANT D'ALIMENTATION DE CIRCUITS INTEGRES

(30) Priorität: 12.05.1999 EP 99109552
(43) Veröffentlichungstag der Anmeldung: 06.02.2002
(73) Patentinhaber: Infineon Technologies AG, 81669 München (DE)
(72) Erfinder: SCHNEIDER, Otto, D-85290 Geisenfeld (DE); UFFMANN, Dirk, D-81825 München (DE)
(74) Vertreter: Epping Hermann & Fischer
(86) Internationale Anmeldenummer: EP0003879
(87) Internationale Veröffentlichungsnummer: WO00070761

(56) Entgegenhaltungen:
- EP-A- 0 544 224
- US-A- 4 797 579
- US-A- 5 041 741
- US-A- 5 598 348
- US-A- 5 625 803

## Beschreibung

Integrierte Schaltungen insbesondere solche zur Verwendung in tragbaren Datenträgern wie Chipkarten bieten viele Manipulations- und/oder Analyseanreize, da sie zunehmend in sicherheitskritischen Bereichen wie Zutrittskontrolle, als wiederaufladbare Geldkarte oder zur Erzeugung elektronischer Unterschriften eingesetzt werden.

Die für die Sicherheit der genannten Anwendungen maßgeblichen Elemente sind zumeist speziell konfigurierte Schaltungsteile oder in nicht-flüchtigen Speichern abgelegte geheime Informationen. Um ein Ausspähen dieser Details zu verhindern wurde in der Vergangenheit vorgeschlagen, Schaltungsteile in tieferen Ebenen der integrierten Schaltung zu realisieren, so daß sie durch darüberliegende Strukturen verdeckt sind. Andere Vorschläge zielten auf eine zusätzliche vorzugsweise leitende Abdeckung der integrierten Schaltung, die in die Stromversorgung einbezogen ist und deren Vorhandensein bzw. Unversehrtheit detektiert werden kann, um den Verarbeitungsablauf in der integrierten Schaltung entsprechend zu beeinflussen. Darüberhinaus ist auch schon eine Verschlüsselung des Datenaustauschs zwischen Bestandteilen einer Schaltung auf einem einzigen Halbleiterchip vorgeschlagen worden.

All diese Schutzmaßnahmen greifen jedoch nicht in ausreichendem Maße bei seit einiger Zeit bekanntgewordenen Analysemethoden, die sich auf die Beobachtung und die statistische Auswertung des von außen meßbaren Versorgungstromprofils bei bestimmungsgemäßem Gebrauch beschränken, ohne also den Halbleiterchip zu verändern. Diese Methoden sind unter der englischen Bezeichnung Single Power Analysis und Differential Power Analysis bekannt geworden und eine kurze Beschreibung dieser Methoden ist beispielsweise in der Internet-Seite http://www.cryptography.com veröffentlicht.

Danach hat es sich gezeigt, daß bei gleichen Abläufen innerhalb der integrierten Schaltung - beispielsweise bei Ausführung des gleichen Befehls in einem Mikroprozessor - das gleiche Stromprofil an der Versorgungsspannungseingangsklemme meßbar ist. Durch statistische Auswertung dieses Stromprofils können sogar einzelne Bits einer für eine Verschlüsselung erforderlichen geheimen Zahl ermittelt werden.

Die Aufgabe vorliegender Erfindung ist es, einen Schutz vor einer solchen Analyse zu bieten.

Die Aufgabe wird durch eine Schaltungsanordnung mit den Merkmalen des Anspruchs 1 gelöst. Vorteilhafte Weiterbildungen sind in den Unteransprüchen angegeben.

Gemäß der Erfindung wird die differentielle Power-Analyse an integrierten Schaltungen, insbesondere an digitalen integrierten CMOS-Schaltungen, erschwert durch die Erzeugung zusätzlicher Pulse im Versorgungsstrom, die insbesondere synchron zu den Flanken des internen Taktsignals der integrierten Schaltung sind. Die Pulsform sowie die Amplitude und der Zeitverlauf sind dabei ähnlich zu den von anderen Schaltungsteilen zum Beispiel von Prozessoren oder von sonstiger digitaler Logik erzeugten Pulsen im Versorgungsstrom, die bei digitalen Schaltungen typischerweise einer Ladekurve eines Kondensators über einen Widerstand entsprechen.

Trotz der gewünschten relativ hohen Pulsamplituden kommt die erfindungsgemäße Schaltungsanordnung mit relativ kleinen Kondensatoren aus, so daß keine große Fläche auf dem Chip benötigt wird. Weiterhin können die Amplitude und die Ladezeitkonstante sowie die Dauer der Strompulse weitgehend unabhängig voneinander eingestellt werden.

Die erfindungsgemäße Schaltungsanordnung kann bei beliebigen integrierten Schaltungen eingesetzt werden, die mit komplementären, zwischen den Versorgungsspannungsanschlüssen in Serie geschalteten Schaltelementen aufgebaut ist, deren Steuereingänge miteinander verbunden sind, so daß immer eines der beiden Schaltelemente durchgeschaltet ist. Wenn im folgenden die wesentlichen Merkmale der Erfindung anhand von CMOS-Schaltungen erläutert werden, soll dies daher keine Einschränkung auf diese Technik bedeuten. Außerdem können die Stromspitzen durch die Schaltflanken beliebiger Steuersignale am Eingangsanschluß einer Schalteinheit oder einer Schaltstufe hervorgerufen werden. Auch hier soll das im folgenden als Beispiel gebrauchte Taktsignal keine Einschränkung auf ein bestimmtes Steuersignal bedeuten.

Eine Ausführungsform der erfindungsgemäßen Schaltungsanordnung benutzt ein Verzögerungsglied am Gate eines der beiden Transistoren einer CMOS-Inverterstufe. Dadurch wird bei einem Signalwechsel am Eingang der CMOS-Inverterstufe der eine Transistor sofort eingeschaltet und der andere Transistor verzögert abgeschaltet. Zwischen diesen beiden Schaltpunkten fließt ein Querstrom durch den CMOS-Inverter, dessen Amplitude im wesentlichen durch die Dimensionierung der Transistoren und dessen Zeitkonstante im wesentlichen durch das Verzögerungsglied am Gate des einen Transistors bestimmt ist.

Eine erfindungsgemäße Schaltungsanordnung kann lediglich mit einer Schalteinheit gebildet sein, bei der am Gate eines der Schaltelemente ein Verzögerungsglied angeordnet ist, es ist jedoch auch möglich, eine Schaltungsanordnung mit zwei in Serie geschalteten Schalteinheiten zu bilden, die einen Vorund eine Endstufe darstellen, und bei der lediglich am Steueranschluß eines der Schaltelemente der Endstufe ein Verzögerungsglied angeordnet ist.

Derartige Schalteinheiten oder Schaltstufen können durch vorgeschaltete Schaltvorrichtungen jeweils aktiviert oder deaktiviert werden, indem ein Steuersignal, insbesondere ein Taktsignal, aufgeschaltet wird oder nicht. Weiterhin kann durch Invertierung des Steuer- oder Taktsignals oder Tausch des jeweils verzögert angesteuerten Steueranschlusses eines Schaltelements festgelegt werden, ob der Strompuls jeweils bei der positiven oder der negativen Flanke des Steuersignals erzeugt wird.

Es können auch mehrere Schalteinheiten oder Schaltstufen, insbesondere mit jeweils unterschiedlichen Amplituden, benutzt werden, um ähnlich wie beim D/A-Umsetzerprinzip eine bestimmte Amplitude in Abhängigkeit der Anzahl der aktivierten Schalteinheiten oder Schaltstufen zu erreichen.

Die Auswahl der Schalteinheiten oder Schaltstufen erfolgt über die Schaltvorrichtungen ansteuernde Steuersignale einer Steuerschaltung, die in einer Ausführung einen als Zufallszahlengenerator ausgebildeten Signalgenerator aufweist, so daß die Amplitude der erzeugten Strompulse einerseits und ihr Erzeugungszeitpunkt bei einer steigenden oder fallenden Steuersignalflanke, insbesondere einer Taktsignalflanke, zufällig variiert. Der Signalgenerator kann in einer anderen Ausführung auch deterministische Signale erzeugen. Die Auswahl hängt vom gewünschten Zweck ab.

Die Erfindung soll nachfolgend anhand von Ausführungsbeispielen mit Hilfe von Figuren näher erläutert werden. Dabei zeigen:
- Figur 1: eine erste Ausführung einer erfindungsgemäßen Schaltungsanordnung mit einer aus einer Vor- und einer Endstufe gebildeten Schaltstufe,
- Figur 2: eine zweite Ausführungsform einer erfindungsgemäßen Schaltungsanordnung,
- Figur 3: eine dritte Ausführungsform der erfindungsgemäßen Schaltungsanordnung mit einer Steuerschaltung zur Auswahl der Schaltflanke des Steuersignals,
- Figur 4: ein die Schaltung gemäß Figur 3 beschreibendes Signaldiagramm,
- Figur 5: eine mehrstufige Schaltungsanordnung zur Erzeugung unterschiedlicher Pulsamplituden,
- Figur 6: ein Beispiel für ein Signaldiagramm zur Beaufschlagung der Eingänge der Schaltung gemäß Figur 5 und
- Figur 7: das aus dem Signaldiagramm gemäß Figur 6 resultierende Stromprofil als Spannungsabfall über einem Meßwiderstand der Schaltung gemäß Figur 5.

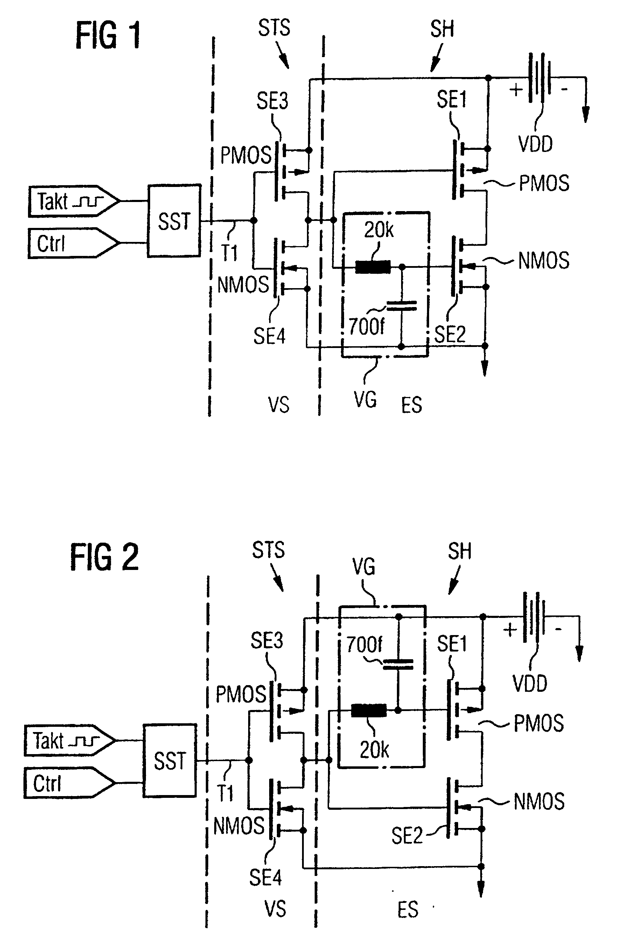

In Figur 1 ist ein mit einem PMOS-Transistor gebildetes erstes Schaltelement SE1 in Serie zu einem mit einem NMOS-Transistor gebildeten zweiten Schaltelement SE2 zwischen einer Versorgungsspannung VDD einer integrierten Schaltung und dem Masseanschluß angeordnet. Die Steuer- bzw. Gateanschlüsse der Schaltelemente SE1, SE2 bzw. MOS-Transistoren sind miteinander verbunden und bilden einen Eingangsanschluß einer durch die Schaltelemente SE1, SE2 gebildeten Schaltungseinheit SH. Zwischen diesem Eingangsanschluß und dem Gateanschluß des NMOS-Transistors ist ein Verzögerungsglied VG angeordnet. Dieses Verzögerungsglied VG ist im dargestellten Beispiel mit einem RC-Glied gebildet, wobei als Beispiel für den Wert des Widerstands 20kΩ und für den Wert des Kondensators 700fF angegeben sind.

Die zuvor beschriebene Schalteinheit SH bildet im Beispiel der Figur 1 die Endstufe ES einer Schaltstufe STS. Dieser Endstufe ES ist eine Vorstufe VS vorgeschaltet, die ebenfalls als Schalteinheit SH mit zwei komplementären Schaltelementen SE3, SE4 im dargestellten Beispiel als CMOS-Inverter ausgebildet ist. Dieser Schaltstufe STS wird ein erstes Steuersignal T1, das insbesondere ein Taktsignal sein kann, von einer Steuerschaltung SST zugeführt. Die Steuerschaltung SST wird ihrerseits mit einem Taktsignal und einem Aktivierungssignal Ctrl beaufschlagt.

Bei der erfindungsgemäßen Schaltstufe STS wird bei einer steigenden Flanke des ersten Steuersignals T1 über den Vorstufen-CMOS-Inverter VS an den Eingangsanschluß des Endstufen-CMOS-Inverters ES eine fallende Flanke geschaltet, durch die der PMOS-Transistor SE1 leitend geschaltet wird, während über das Verzögerungsglied VG der NMOS-Transistor SE2 erst verzögert abgeschaltet wird. Hierdurch fließt ein Strompuls von der Versorgungsspannung VDD über die Transistoren nach Masse, dessen Amplitude durch das Breiten/Längenverhältnisse der Transistorkanäle und dessen Dauer durch die Verzögerungszeit des Verzögerungsglieds VG bestimmt wird. Durch den Grad der Unsymmetrie der Breiten/Längenverhältnisse der Transistorkanäle kann die Pulsdauer eingestellt werden. Die Einstellung der einzelnen Pulsparameter erfolgt bei der erfindungsgemäßen Schaltungsanordnung weitgehend unabhängig voneinander.

In Figur 2 ist eine weitere Ausführungsform der erfindungsgemäßen Schaltungsanordnung dargestellt, die sich von der Schaltungsanordnung gemäß Figur 1 lediglich darin unterscheidet, daß das Verzögerungsglied VG nicht zwischen dem Eingangsanschluß der Endstufenschalteinheit ES und dem Gateanschluß des NMOS-Transistor-Schaltelements SE2, sondern zwischen dem Eingangsanschluß der Endstufenschalteinheit ES und dem Gateanschluß des PMOS-Transistor-Schaltelements SE1 angeordnet ist. Dies führt dazu, daß der Strompuls bei einer fallenden Flanke des ersten Steuersignals T1 am Eingang einer aus einer Vorstufe VS und einer Endstufe ES aufgebauten Schaltstufe STS erzeugt wird.

Bei den in den Figuren 1 und 2 dargestellten Ausführungsformen ist das Verzögerungsglied VG mit einem RC-Glied gebildet, wobei in Figur 1 der Kondensator gegen Masse und in Figur 2 der Kondensator gegen die Versorgungsspannung VDD geschaltet ist. Es wäre ebenso möglich, in Figur 1 den Kondensator gegen die Versorgungsspannung VDD und in Figur 2 gegen Masse zu schalten. Statt mit einem RC-Glied kann das Verzögerungsglied VG auch mit logischen Gattern, die geeignete Verzögerungszeiten aufweisen, oder mit einer Kombination von Gattern mit Kondensatoren gebildet werden.

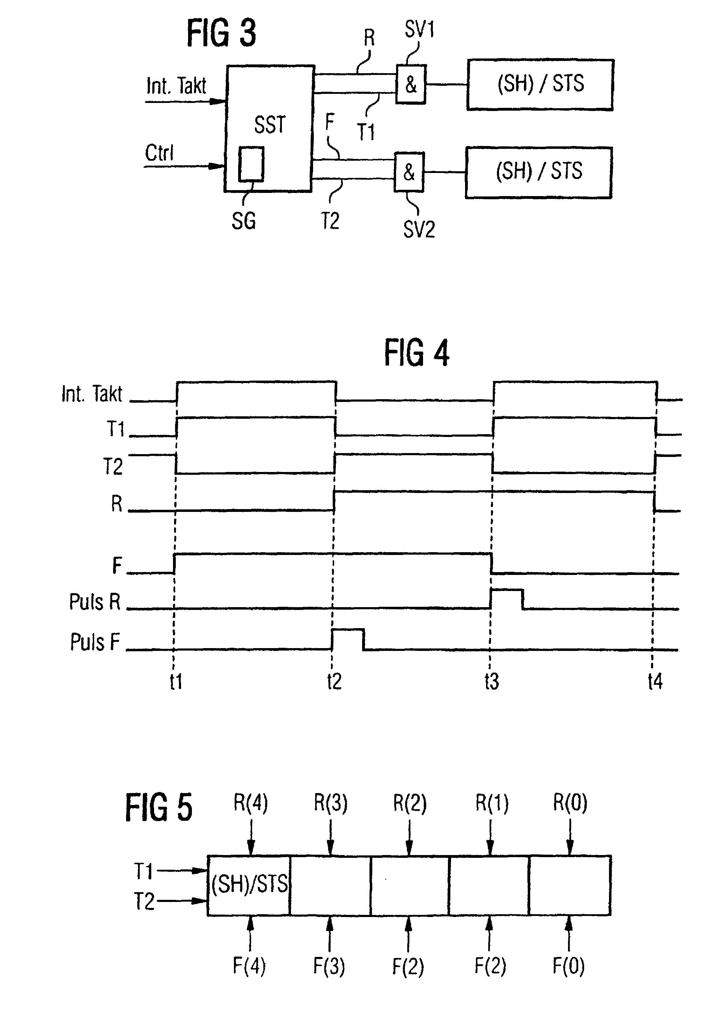

Da mittels der durch die erfindungsgemäße Schaltungsanordnung erzeugten Strompulse das tatsächliche Stromprofil einer integrierten Schaltung verschleiert werden soll, um eine Auswertung mittels der Differential-Power-Analysis-Methode zu erschweren, ist es wünschenswert, die Strompulse zufällig schwankend mal bei einer steigenden und mal bei einer fallenden Flanke des ersten Steuersignals T1 zu erzeugen. Ein Beispiel für eine Schaltungsanordnung, mit der bei einer steigenden und/oder bei einer fallenden Flanke eines Steuersignals ein Strompuls erzeugt werden kann, ist in Figur 3 angegeben.

In der Figur 3 ist angegeben, daß eine solche Schaltungsanordnung sowohl mit einer Schalteinheit SH als auch mit einer Schaltstufe STS gebildet sein kann. Dies gilt jedoch nur prinzipiell, da eine Schaltstufe STS aufgrund des zusätzlichen Inverters bei einer anderen Flanke des Steuersignals einen Puls erzeugt als eine Schalteinheit SH. Die folgenden Angaben zur Figur 3 beziehen sich auf eine Schaltstufe STS.

Gemäß der dortigen Ausführungsform sind zwei identische Schaltstufen STS vorgesehen, die jeweils über eine Schaltvorrichtung SV1 bzw. SV2, die im dargestellten Beispiel mit einem UND-Gatter gebildet ist, mit einem ersten Steuersignal T1 bzw. mit einem zweiten Steuersignal T2, das komplementär zum ersten Steuersignal T1 ist, angesteuert werden können. Die Auswahl erfolgt über ein erstes Auswahlsignal R, durch das ein Strompuls bei einer steigenden Flanke des ersten Steuersignals T1 erzeugt werden soll beziehungsweise durch ein zweites Auswahlsignal F, durch das ein Strompuls bei einer fallenden Flanke des ersten Steuersignals T1 bzw. bei einer steigenden Flanke des dazu komplementären zweiten Steuersignals T2 erzeugt werden soll.

Sämtliche Steuersignale T1, T2, R, F werden durch eine Steuerschaltung SST erzeugt, die ihrerseits von einem internen Taktsignal Int.Takt sowie von einem Aktivierungssignal Ctrl angesteuert wird. Die Schaltstufen STS sind für das in Figur 3 gewählte Beispiel gemäß Figur 1 ausgebildet. Die Funktion der Schaltung gemäß Figur 3 soll nun anhand des Signaldiagramms gemäß Figur 4 erläutert werden.

In einer auf einem Halbleiterchip realisierten integrierten Schaltung sorgt ein Taktsignal für die Synchronisation einzelner Abläufe. Schaltvorgänge finden meistens bei steigenden oder fallenden Flanken dieses Taktsignals statt. Ein solches internes Taktsignal INT.TAKT ist in Figur 4 als Bezugssignal, das auch der Steuerschaltung SST in Figur 3 zugeführt wird, dargestellt. Aus diesem internen Taktsignal INT.TAKT leitet die Steuerschaltung SST das erste Steuersignal T1, das dazu komplementäre zweite Steuersignal T2 sowie die Auswahlsignale R, F ab.

Es wurden im dargestellten, bevorzugten Ausführungsbeispiel zwei komplementäre Steuersignale T1, T2 gewählt, um nur einen Schaltstufentyp realisieren zu müssen. Prinzipiell würde auch ein Steuersignal ausreichen, dessen steigende und fallende Flanke ausgewertet werden kann. In diesem Fall wären allerdings zwei Schaltstufentypen gemäß der Figuren 1 und 2 nötig.

In Figur 4 entspricht das erste Steuersignal T1 etwa dem Bezugssignal INT.TAKT, da es sinnvoll ist, die zu erzeugenden Strompulse zum gleichen Zeitpunkt zu erzeugen, zu dem auch die schaltungsbedingten Strompulse des Stromprofils der integrierten Schaltung erzeugt werden.

Das erste Auswahlsignal R muß die erste Schaltvorrichtung SV1 in einem Zeitbereich aktivieren, in dem eine steigende Flanke des ersten Steuersignals T1 auftritt. Da die steigende Flanke des zweiten Steuersignals T2 um eine halbe Periodendauer verschoben zur steigenden Flanke des ersten Steuersignals T1 auftritt, muß das zweite Auswahlsignal F ebenfalls verschoben sein, was in Figur 4 dargestellt ist.

Wie aus Figur 4 weiter zu erkennen ist, wird immer, wenn das erste Auswahlsignal R die erste Schaltvorrichtung SV1 aktiviert, im dargestellten Beispiel eines UND-Gatters also einen High-Pegel aufweist, bei einer steigenden Flanke des ersten Steuersignals T1 ein Strompuls (R) erzeugt. In entsprechender Weise wird ein Strompuls (F) erzeugt, wenn das zweite Auswahlsignal F die zweite Schaltvorrichtung SV2 aktiviert und eine steigende Flanke im zweiten Steuersignal T2 auftritt.

Wenn unterschiedlich hohe Amplituden in den Strompulsen erzeugt werden sollen, können mehrere Schaltungsanordnungen gemäß Figur 3 bezüglich der Steuersignale T1, T2 parallel geschaltet werden. Dies ist in Figur 5 am Beispiel von fünf Schaltstufen STS dargestellt. Es sind dabei jeweils fünf Auswahlsignale R(0)...R(4) für Strompulse bei steigenden Flanken und fünf Auswahlsignale F(0)...F(4) für Strompulse bei fallenden Flanken vorgesehen.

In vorteilhafter Weise können die Schaltstufen STS derart dimensioniert sein, daß die Pulsamplituden einer Schaltstufe STS doppelt so hoch ist wie die einer benachbarten Schaltstufe STS, also beispielsweise die normierten Werte 1, 2, 4, 8 und 16 aufweisen.

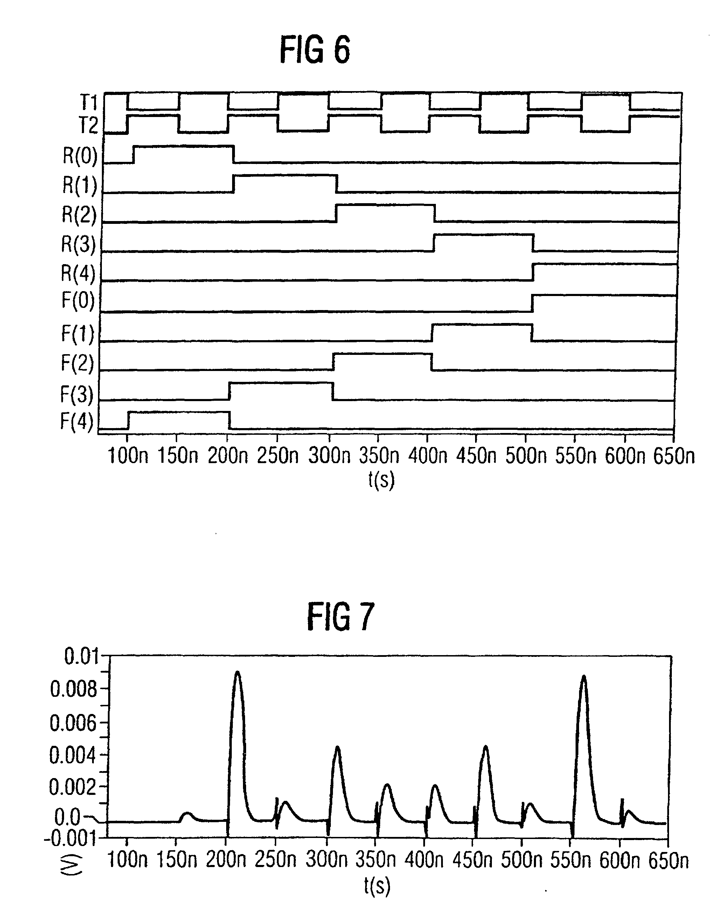

In Figur 7 ist dargestellt, welche Strompulsfolge mit einer Schaltungsanordnung gemäß Figur 5 erzeugt werden kann, wenn Auswahlsignale gemäß Figur 6 an die Schaltungsanordnung angelegt werden.

Bei der Schaltungsanordnung gemäß Figur 5 sind eine Gruppe von fünf Schaltstufen STS bezüglich des ersten Steuersignals T1 und eine weitere Gruppe von ebenfalls fünf Schaltstufen STS bezüglich des zweiten Steuersignals T2 parallel geschaltet.

Die Schaltstufen STS der Gruppe erzeugen dabei abhängig vom Zustand der Auswahlsignale R(0)...R(4) Strompulse bei steigenden Flanken des ersten Steuersignals T1, während die Schaltstufen STS der weiteren Gruppe abhängig vom Zustand der Auswahlsignale F(0)...F(4) Strompulse bei fallenden Flanken des ersten Steuersignals T1 bzw. aufgrund der Komplementarität bei steigenden Flanken des zweiten Steuersignals T2 erzeugen. Die Schaltstufen STS sind dabei prinzipiell gleich aufgebaut, so daß sie bei steigenden Flanken Strompulse erzeugen. Wie der Darstellung in Figur 6 zu entnehmen ist, kann es nötig sein, die zweiten Auswahlsignale F(0)...F(4) beispielsweise durch eine Latchschaltung etwas zu verzögern, um sicherzustellen, daß die steigende Flanke des zweiten Steuersignals T2 während des Anliegens der zweiten Auswahlsignale F(0)...F(4) auftritt.

Es wäre aber auch möglich, eine erste Gruppe von Schaltstufen STS zu bilden, die bei steigenden Flanken des ersten Steuersignals T1 einen Strompuls erzeugen und eine zweite Gruppe von Schaltstufen SST zu bilden, die bei einer fallenden Flanke des ersten Steuersignals T1 einen Strompuls erzeugen, die alle bezüglich des ersten Steuersignals T1 parallel geschaltet sind. Hierbei müßten jedoch, wie bereits zu Figur 3 ausgeführt wurde, unterschiedliche Typen von Schaltstufen STS benutzt werden.

Mit der in den Figuren erläuterten erfindungsgemäßen Schaltungsanordnung können also bei beliebigen Flanken eines Taktsignals gesteuert durch einen Signalgenerator SG Strompulse unterschiedlicher Höhe im Versorgungsstrom einer integrierten Schaltung erzeugt werden und so dem Stromprofil der integrierten Schaltung ein Rauschen überlagert werden, so daß eine Einfache oder Differentielle Power Analyse deutlich erschwert, wenn nicht gar verhindert wird.

## Patentansprüche

1. Schaltungsanordnung zur Erzeugung von Strompulsen im Versorgungsstrom integrierter Schaltungen mit zumindest einer mit zwei komplementären, zwischen den Versorgungsspannungen (VDD, Masse) der integrierten Schaltung in Serie geschalteten, steuerbaren Schaltelementen (SE1, SE2; SE3, SE4) gebildeten Schalteinheit (SH; VS, ES), deren durch ein erstes Steuersignal (T1) ansteuerbarer Eingangsanschluß mit den Steueranschlüssen der Schaltelemente (SE1, SE2; SE3, SE4) verbunden ist, wobei zwischen dem Eingangsanschluß und entweder dem Steueranschluß des Pull-Up-Schaltelements (SE1, SE3) oder dem Steueranschluß des Pull-Down-Schaltelements (SE2, SE4) ein Verzögerungsglied (VG) angeordnet ist, so daß entweder bei einer steigenden oder einer fallenden Flanke des ersten Steuersignals (T1) ein Strompuls erzeugt wird.

2. Schaltungsanordnung nach Anspruch 1, **dadurch gekennzeichnet, daß** der Schalteinheit (ES) eine weitere Schalteinheit (VS) vorgeschaltet ist, deren Eingangsanschluß direkt mit den Steueranschlüssen der sie bildenden komplementären Schaltelemente (T3, T4) verbunden ist und deren Ausgangsanschluß durch den Verbindungspunkt der beiden komplementären Schaltelemente (T3, T4) gebildet ist, wobei die Serienschaltung dieser Schalteinheiten (VS, ES) eine Schaltstufe (STS) bildet, deren Eingangsanschluß mit dem ersten Steuersignal (T1) ansteuerbar ist.

3. Schaltungsanordnung nach Anspruch 1 oder 2, **dadurch gekennzeichnet, daß** eine Schalteinheit (SH; VS, ES) mit einer CMOS-Inverterschaltung gebildet ist.

4. Schaltungsanordnung nach einem der vorhergehenden Ansprüche, **dadurch gekennzeichnet, daß** mehrere Schalteinheiten (SH) oder Schaltstufen (STS) bezüglich des ersten Steuersignals (T1) parallelgeschaltet sind und das erste Steuersignal (T1) jeweils über eine von einer Steuerschaltung (SST) ansteuerbaren Schaltvorrichtung (SV1, SV2) einer jeweiligen Schalteinheit (SH) oder Schaltstufe (STS) zuführbar ist.

5. Schaltungsanordnung nach Anspruch 4, **dadurch gekennzeichnet, daß** die Schalteinheiten (SH; VS, ES) oder Schaltstufen (STS) derart dimensioniert sind, daß sie unterschiedlich hohe Strompulse erzeugen.

6. Schaltungsanordnung nach einem der Ansprüche 4 oder 5, **dadurch gekennzeichnet, daß** die Schalteinheiten (SH; VS, ES) oder Schaltstufen (STS) derart gebildet sind, daß die Strompulse bei einer steigenden Flanke des ersten Steuersignals (T1) erzeugt werden.

7. Schaltungsanordnung nach einem der Ansprüche 4 oder 5, **dadurch gekennzeichnet, daß** die Schalteinheiten (SH; VS, ES) oder Schaltstufen (STS) derart gebildet sind, daß die Strompulse bei einer fallenden Flanke des ersten Steuersignals (T1) erzeugt werden.

8. Schaltungsanordnung nach einem der Ansprüche 4 oder 5, **dadurch gekennzeichnet, daß** die Schalteinheiten (SH; VS, ES) oder Schaltstufen (STS) einer ersten Gruppe derart gebildet sind, daß die Strompulse bei einer steigenden Flanke des ersten Steuersignals (T1) erzeugt werden und die Schalteinheiten (SH; VS, ES) oder Schaltstufen (STS) einer zweiten Gruppe derart gebildet sind, daß die Strompulse bei einer fallenden Flanke des ersten Steuersignals (T1) erzeugt werden.

9. Schaltungsanordnung nach einem der Ansprüche 1 bis 3, **dadurch gekennzeichnet,**
**daß** eine erste Anzahl von Schalteinheiten (SH; VS, ES) oder Schaltstufen (STS) bezüglich des ersten Steuersignals (T1) parallelgeschaltet sind und eine Gruppe bilden und das erste Steuersignal (T1) jeweils über eine von einer Steuerschaltung (SST) ansteuerbaren Schaltvorrichtung (SV1) einer jeweiligen Schalteinheit (SH) oder Schaltstufe (STS) der Gruppe zuführbar ist, wobei die Schalteinheiten (SH; VS, ES) oder Schaltstufen (STS) der Gruppe derart gebildet sind, daß die Strompulse bei einer steigenden Flanke des ersten Steuersignals (T1) erzeugt werden,
und **daß** eine zweite Anzahl von Schalteinheiten (SH) oder Schaltstufen (STS) bezüglich eines zweiten, zum ersten Steuersignal (T1) komplementären Steuersignals (T2) parallelgeschaltet sind und eine weitere Gruppe bilden und das zweite Steuersignal (T2) jeweils über eine von der Steuerschaltung (SST) ansteuerbaren Schaltvorrichtung (SV2) einer jeweiligen Schalteinheit (SH) oder Schaltstufe (STS) der weiteren Gruppe zuführbar ist, wobei die Schalteinheiten (SH) oder Schaltstufen (STS) der weiteren Gruppe derart gebildet sind, daß die Strompulse bei einer steigenden Flanke des zweiten Steuersignal (T2) bzw. einer fallenden Flanke des ersten Steuersignals (T1) erzeugt werden.

10. Schaltungsanordnung nach einem der Ansprüche 4 bis 9, **dadurch gekennzeichnet, daß** die Steuerschaltung (SST) einen Signalgenerator (SG) zur Erzeugung von Bitmustern zur Ansteuerung der Schaltvorrichtungen (SV1, SV2) aufweist.

11. Schaltungsanordnung nach Anspruch 10, **dadurch gekennzeichnet, daß** der Signalgenerator (SG) ein Zufallszahlengenerator ist.

## Claims

1. Circuit arrangement for generating current pulses in the supply current of integrated circuits having at least one switching unit (SH; VS, ES), which is formed with two complementary controllable switching elements (SE1, SE2; SE3, SE4) connected in series between the supply voltages (VDD, ground) of the integrated circuit and whose input terminal, which can be driven by a first control signal (T1), is connected to the control terminals of the switching elements (SE1, SE2; SE3, SE4), wherein a delay element (VG) is arranged between the input terminal and either the control terminal of the pull-up switching element (SE1, SE3) or the control terminal of the pull-down switching element (SE2, SE4), with the result that a current pulse is generated either in the event of a rising or falling edge of the first control signal (T1).

2. Circuit arrangement according to Claim 1, **characterized in that** there is connected upstream of the switching unit (ES) a further switching unit (VS), whose input terminal is directly connected to the control terminals of the complementary switching elements (T3, T4) forming it and whose output terminal is formed by the junction point between the two complementary switching elements (T3, T4), wherein the series circuit of these switching units (VS, ES) forms a switching stage (STS) whose input terminal can be driven with the first control signal (T1).

3. Circuit arrangement according to Claim 1 or 2, **characterized in that** a switching unit (SH; VS, ES) is formed with a CMOS inverter circuit.

4. Circuit arrangement according to one of the preceding claims, **characterized in that** a plurality of switching units (SH) or switching stages (STS) are connected in parallel with regard to the first control signal (T1) and the first control signal (T1) can be fed to a respective switching unit (SH) or switching stage (STS) in each case via a switching device (SV1, SV2) which can be driven by a control circuit (SST).

5. Circuit arrangement according to Claim 4, **characterized in that** the switching units (SH; VS, ES) or switching stages (STS) are dimensioned in such a way that they generate current pulses of different magnitudes.

6. Circuit arrangement according to either of Claims 4 and 5, **characterized in that** the switching units (SH; VS, ES) or switching stages (STS) are formed in such a way that the current pulses are generated in the event of a rising edge of the first control signal (T1).

7. Circuit arrangement according to either of Claims 4 and 5, **characterized in that** the switching units (SH; VS, ES) or switching stages (STS) are formed in such a way that the current pulses are generated in the event of a falling edge of the first control signal (T1).

8. Circuit arrangement according to either of Claims 4 and 5, **characterized in that** the switching units (SH; VS, ES) or switching stages (STS) of a first group are formed in such a way that the current pulses are generated in the event of a rising edge of the first control signal (T1), and the switching units (SH; VS, ES) or switching stages (STS) of a second group are formed in such a way that the current pulses are generated in the event of a falling edge of the first control signal (T1).

9. Circuit arrangement according to one of Claims 1 to 3, **characterized**
**in that** a first number of switching units (SH; VS, ES) or switching stages (STS) are connected in parallel with regard to the first control signal (T1) and form a group and the first control signal (T1) can be fed to a respective switching unit (SH) or switching stage (STS) of the group in each case via a switching device (SV1) which can be driven by a control circuit (SST), the switching units (SH; VS, ES) or switching stages (STS) of the group being formed in such a way that the current pulses are generated in the event of a rising edge of the first control signal (T1),
and **in that** a second number of switching units (SH) or switching stages (STS) are connected in parallel with regard to a second control signal (T2), complementary to the first control signal (T1), and form a further group and the second control signal (T2) can be fed to a respective switching unit (SH) or switching stage (STS) of the further group in each case via a switching device (SV2) which can be driven by the control circuit (SST), the switching units (SH) or switching stages (STS) of the further group being formed in such a way that the current pulses are generated in the event of a rising edge of the second control signal (T2) or a falling edge of the first control signal (T1).

10. Circuit arrangement according to one of Claims 4 to 9, **characterized in that** the control circuit (SST) has a signal generator (SG) for generating bit patterns for driving the switching devices (SV1, SV2).

11. Circuit arrangement according to Claim 10, **characterized in that** the signal generator (SG) is a random number generator.

## Revendications

1. Montage de production d'impulsions de courant dans le courant d'alimentation de circuits intégrés comprenant au moins une unité (SH ; VS, ES) de commutation formée de deux éléments (SE1, SE2; SE3, SE4) de commutation complémentaire pouvant être commandés, montés en série entre les tensions (VDD, masse) d'alimentation du circuit intégré, et dont la borne d'entrée, qui peut être commandée par un premier signal (T1) de commande, est reliée aux bornes de commande des éléments (SE1, SE2; SE3, SE4) de commutation, un élément (VG) à retard étant monté entre la borne d'entrée et soit la borne de commande de l'élément (SE1, SE3) de commutation Pull-Up, soit la borne de commande de l'élément (SE2, SE4) de commutation Pull-Down, de manière à produire une impulsion de courant, soit lors d'un front montant, soit lors d'un front descendant du premier signal (T1) de commande.

2. Montage suivant la revendication 1, **caractérisé en ce qu'**il est monté en amont de l'unité (ES) de commutation une autre unité (VS) de commutation, dont la borne d'entrée est reliée directement aux bornes de commande des éléments (T3, T4) de commutation complémentaires qui la forment, et dont la borne de sortie est formée par le point de liaison des deux éléments (T3, T4) de commutation complémentaires, le circuit série de ces unités (VS, ES) de commutation formant un étage (STS) de commutation, dont la borne d'entrée peut être commandée par le premier signal (T1) de commande.

3. Montage suivant la revendication 1 ou 2, **caractérisé en ce qu'**une unité (SH; VS, ES) de commutation est formée par un circuit inverseur CMOS.

4. Montage suivant l'une des revendications précédentes, **caractérisé en ce que** plusieurs unités (SH) de commutation ou étages (STS) de commutation sont montés en parallèle en ce qui concerne le premier signal (T1) de commande et le premier signal (T1) de commande peut être envoyé respectivement par un dispositif (SV1, SV2) de commutation, pouvant être commandé par un circuit (SST) de commande, d'une unité (SH) respective de commutation ou d'un étage (STS) respectif de commutation.

5. Montage suivant la revendication 4, **caractérisé en ce que** les unités (SH; VS, ES) de commutation ou les étages (STS) de commutation ont des dimensions telles qu'ils produisent des impulsions de courant d'amplitude différente.

6. Montage suivant l'une des revendications 4 ou 5, **caractérisé en ce que** les unités (SH; VS, ES) de commutation ou les étages (STS) de commutation sont constitués de façon à ce que les impulsions de courant soient produites pour un front montant du premier signal (T1) de commande.

7. Montage suivant la revendication 4 ou 5, **caractérisé en ce que** les unités (SH; VS, ES) de commutation ou les étages (STS) de commutation sont formés de façon à ce que les impulsions de courant soient produites pour un front descendant du premier signal (T1) de commande.

8. Montage suivant l'une des revendications 4 ou 5, **caractérisé en ce que** les unités (SH; VS, ES) de commutation ou les étages (STS) de commutation d'un premier groupe sont formés de façon à ce que les impulsions de courant soient produites pour un front montant du premier signal (T1) de commande et les unités (SH; VS, ES) de commutation ou les étages (STS) de commutation d'un deuxième groupe sont formés de façon à ce que les impulsions de courant soient produites pour un front descendant du premier signal (T1) de commande.

9. Montage suivant l'une des revendications 1 à 3, **caractérisé en ce qu'**un premier nombre d'unités (SH; VS, ES) de commutation ou d'étages (STS) de commutation sont montés en parallèle en ce qui concerne le premier signal (T1) de commande, et forment un groupe et le premier signal (T1) de commande peut être envoyé par un dispositif (SV1) de commutation, qui peut être commandé par un circuit (SST) de commande, d'une unité (SH) respective de commutation ou d'un étage (STS) de commutation du groupe, les unités (SH, VS, ES) de commutation ou les étages (STS) de commutation du groupe étant formés de façon à ce que les impulsions de courant soient produites pour un front montant du premier signal (T1) de commande,
et **en ce qu'**un deuxième nombre d'unités (SH) de commutation ou d'étages (STS) de commutation sont montés en parallèle pour ce qui concerne un deuxième signal (T2) de commande complémentaire du premier signal (T1) de commande et forment un autre groupe et **en ce que** le deuxième signal (T2) de commande peut être envoyé respectivement par un dispositif (SV2) de commutation, qui peut être commandé par le circuit (SST) de commande, d'une unité (SH) respective de commutation ou d'un étage (STS) respectif de commutation de l'autre groupe, les unités (SH) de commutation ou les étages (STS) de commutation de l'autre groupe étant formés de façon à ce que les impulsions de courant soient produites pour un front montant du deuxième signal (T2) de commande ou un front descendant du premier signal (T1) de commande.

10. Montage suivant l'une des revendications 4 à 9, **caractérisé en ce que** le circuit (SST) de commande comporte un générateur (SG) de signal destiné à produire des modèles de bits pour la commande des dispositifs (SV1, SV2) de commutation.

11. Montage suivant la revendication 10, **caractérisé en ce que** le générateur (SG) de signal est un générateur de nombre aléatoire.
